# EUROPEAN PATENT APPLICATION

(11) **EP 4 617 701 A1**
(43) Date of publication of application: **17.09.2025**
(21) Application number: 24163813.9
(22) Date of filing: 15.03.2024
(51) Int. Cl.: G01R 33/561

(54) **COMPUTER-IMPLEMENTED METHOD FOR OPERATING A MAGNETIC RESONANCE DEVICE FOR ACQUIRING MAGNETIC RESONANCE DATA, MAGNETIC RESONANCE DEVICE, COMPUTER PROGRAM AND ELECTRONICALLY READABLE STORAGE MEDIUM**

(71) Applicant: Siemens Healthineers AG, 91301 Forchheim (DE)
(72) Inventor: The designation of the inventor has not yet been filed
(74) Representative: Siemens Healthineers Patent Attorneys

(57) **Abstract**

The invention relates to a computer-implemented method for operating a magnetic resonance device (26) for acquiring magnetic resonance data, wherein an, in particular three-dimensional, slab-selective turbo spin echo sequence having at least one echo train is used, each echo train comprising an excitation module (12) with an excitation pulse (14, 19) preceding a readout module (17), which comprises multiple refocusing pulses (18) and associated readout intervals, characterized in that the excitation pulse (14, 19) is at least partly implemented as a variable rate selective excitation pulse (13), wherein the readout module (17) immediately succeeds the excitation module (12).

## Description

The invention concerns a computer-implemented method for operating a magnetic resonance device for acquiring magnetic resonance data, wherein an, in particular three-dimensional, slab-selective turbo spin echo sequence having at least one echo train is used, each echo train comprising an excitation module with an excitation pulse preceding a readout module, which comprises multiple refocusing pulses and associated readout intervals. The invention further concerns a magnetic resonance device, a computer program and an electronically readable storage medium.

Spin echo sequences are a workhorse in magnetic resonance imaging. To accelerate image acquisition, turbo spin echo (TSE, also known as fast spin echo (FSE) and originally proposed as Rapid Acquisition with Relaxation Enhancement (RARE)) sequences have been proposed, in which multiple echoes are acquired using the same excitation pulse, such that the excitation module and the following readout module may also be called an echo train, while the readout module itself may be understood as a refocusing train. In the readout module, each readout interval is preceded by a refocusing pulse (π pulse). Here, the flip angle of the refocusing pulse does not have to be 180°, since approaches for reducing the flip angle and hence specific absorption rate (SAR) are known. For example, in SPACE (Sampling Perfection with Application optimized Contrast using different flip angle Evolution) sequences, it has been proposed to significantly reduce SAR at comparable signal-to-noise ratio (SNR) by replacing a constant low flip angle refocusing train by a variable flip angle refocusing train designed to produce a constant echo amplitude. Starting the pulse train with higher amplitude refocusing pulses and slowly decreasing to approach a constant ("asymptotic") value enables acquisition of images with SNR values close to those acquired with 180° refocusing pulses, for asymptotic flip angles as low as 60°.

Three-dimensional TSE sequences may be non-selective. Here, the excitation is not confined to a certain slice or slab. The excitation pulse and the refocusing pulses are both non-selective.

For slab-selective TSE sequences, at least the excitation pulse must be slab-selective. However, slab-selective excitation pulses have a longer duration. One of the reasons is that the excited slab needs to have a precise profile. As a consequence, the duration of the excitation pulse limits the echo spacing of the refocusing train. In SPACE, for example, the echo spacing is twice the time between the center of the excitation pulse and the center of the first refocusing pulse. Thus, increasing the duration of the excitation pulse would cause an increase in the echo spacing, which has detrimental effects on image quality.

For slab-selective SPACE, it has been proposed to use an additional refocusing module following the slab-selective excitation pulse in the excitation module. In this additional refocusing module, a non-selective 180° pulse generates a spin echo, which is used as the "new input" for the readout module (refocusing train). The method allows a reduction of the echo spacing to the same value as the non-selective SPACE. However, there are some disadvantages and challenges.
- The flip angle of the 180° pulse must be very precise. Otherwise, only a part of the signal would be refocused and a significant part of the signal would be lost before the acquisition in the refocusing train. A precise flip angle over the complete field of view cannot be guaranteed, in particular for MRI systems with a main magnetic field (B0 field) strength of 3 Tesla or higher.
- Since the first echo has a different echo spacing compared to the successive echoes, its higher-order echoes cannot contribute to the refocusing train without creating banding artifacts. To solve this problem, a crusher gradient pulse is output after the 180° pulse in the additional refocusing module to crush the contribution of the first echo. However, this can reduce the available signal for the successive refocusing train, in particular if there are main magnetic field (80 field) and excitation magnetic field (B1 field) imperfections.
- To achieve a flip angle of 180°, a high radio frequency amplitude is needed. To reduce the maximum radio frequency amplitude needed (in particular due to SAR limitations), the duration of the 180° pulse is increased compared to the other refocusing pulses of the refocusing train, resulting in a lower bandwidth and increased susceptibility to artifacts caused by B0 imperfections.
- The addition of the additional refocusing module to each echo train increases the minimum echo time (TE) achievable. TE is a crucial parameter for the image quality of T1-weighted or proton density (PD)-weighted TSE imaging.
- To achieve a precise slab selection, that is, an accurate slab profile, the radio frequency pulse of the excitation module has a high time-bandwidth product and hence a long duration. This can result in off-resonant tissues being shifted in the slab selection direction defined by the gradient pulse of the excitation module, which causes a geometrical inaccuracy.

It is an object of the current invention to provide a way to improve image quality of selective 3D-TSE imaging, in particular avoiding or at least mitigating the disadvantages encountered in an additional refocusing module approach.

This object is achieved by providing a computer-implemented method, a magnetic resonance device, a computer program and an electronically readable storage medium according to the independent claims. Advantageous embodiments are described by the dependent claims.

In a method for operating a magnetic resonance device for acquiring magnetic resonance data, wherein an, in particular three-dimensional, slab-selective turbo spin echo sequence having at least one echo train is used, each echo train comprising an excitation module with an excitation pulse preceding a readout module, which comprises multiple refocusing pulses and associated readout intervals, according to the invention, the excitation pulse is at least partly implemented as a variable rate selective excitation pulse, wherein the readout module immediately succeeds the excitation module.

Here, a slab-selective excitation pulse is understood as comprising a gradient pulse and a radio frequency pulse (RF pulse). In a variable rate selective excitation pulse (VERSE pulse), both the gradient pulse and the radio frequency pulse are time-varying and may, for example, be determined in an optimization procedure, in particular minimizing duration. In other words, instead of a slab selective gradient with a constant gradient strength, VERSE pulses use slab selective gradients with time-varying gradient strength. VERSE pulses of minimized duration have been proposed, for example, by Brian A. Hargreaves et al. in "Variable-Rate Selective Excitation for Rapid MRI Sequences", MRM 52 (2004), pages 590-597. It is also referred to US 2006/0061358 A1.

It is hence proposed to replace a conventional excitation pulse using constant gradient strength at least partly with a VERSE pulse having a reduced duration. The reduction in the excitation pulse duration is realized by the time modulation of the radio frequency pulse and of the gradient pulse (slab-selective gradient). In other words, the VERSE pulse part of the excitation pulse may have a duration which is at least five times shorter than a corresponding part having a constant gradient strength, in particular at least nine times shorter. VERSE allows, for example, to reduce the duration of the slab selective excitation pulse by nearly a factor of ten, which, in particular, allows the removal of the additional refocusing module mentioned above. In advantageous embodiments, the variable rate selective excitation pulse is determined by minimizing its duration. Such pulses are also called minimum-time VERSE pulses and have been introduced in the article by Hargreaves et al. and corresponding US patent application mentioned above for SSFP sequences.

Using VERSE pulses is advantageous in many ways, in particular in comparison to using an additional refocusing module. Generally, improved image quality is achieved for many MRI applications that use slab-selective 3D-TSE sequences. The signal-to-noise ratio (SNR) is improved. An additional refocusing module is no longer required, since the excitation pulse duration is considerably shorter, allowing an adequate choice of timing, in particular echo times.

In contrast to using an additional refocusing module, where the sensitivity to B0 and B1 imperfections is increased compared to the non-selective case, in the VERSE implementation, the sequence is less prone to B0 and B1 artifacts and behaves similarly to the non-selective case. A crusher gradient for "crushing" transverse magnetization before the first echo is no longer necessary, such that all available signal can be used in the readout module. Furthermore, VERSE allows to shorten the minimum echo time (TE), increasing the available signal. This is relevant especially for the image quality of proton density (PD) and T1-weighted 3D-TSE sequences. Finally, geometrical shifts in the selected slab are reduced, since the VERSE pulse is shorter. Hence, less geometrical imperfections occur.

In embodiments, the excitation pulse may be completely implemented as a variable rate selective excitation pulse. Using only a VERSE pulse allows a very short excitation module, and, consequently, a reduced duration of each echo train, such that the imaging time can advantageously be reduced.

However, VERSE pulses come with the disadvantage that they are more prone to off-resonances caused, for example, by B0 inhomogeneities or chemical shifts. To improve on this, in an especially preferred embodiment of the invention, the excitation pulse comprises a first section implemented as a first half of a slab-selective excitation pulse having a constant gradient pulse and a second section implemented as a variable rate selective excitation pulse, wherein the second section has a shorter duration than the first section.

Hence, a "mixed" pulse can be used. The first section comprises half a usual radio frequency pulse with a constant gradient pulse and the second section a VERSE pulse with a time-varying gradient. Since timing usually refers to the middle of the excitation pulse, it is sufficient to accelerate the second half of the excitation pulse. While it is generally noted that known techniques for determining minimum-time VERSE pulses, as for example proposed by Hargreaves et al., such approaches may also be applied to determining parts of excitation pulses, when the conventional part defines the starting conditions.

It is further noted that, if an additional refocusing module should still be used for some reason, using a "mixed" pulse as discussed above would also allow to reduce refocusing moment without increasing the echo spacing.

In examples, the three-dimensional slab-selective TSE sequence may be a slab-selective SPACE sequence. However, other concrete implementations of 3D-TSE sequences may also be used, while, generally, approaches using a reduced and/or variable flip angle are preferred.

Regarding the readout module, it may preferably comprise a CPMG (Car-Purcell-Meiboom-Gill) readout train. In this manner, in particular, SNR may additionally be improved.

A magnetic resonance device according to the invention comprises a main magnet for generating a main magnetic field, acquisition equipment comprising a gradient coil assembly and a radio frequency coil assembly for outputting gradient pulses and radio frequency pulses, respectively, and a control device, wherein the control device comprises an acquisition unit operative to acquire magnetic resonance data using the acquisition equipment and adapted to acquire magnetic resonance data using an, in particular three-dimensional, slab-selective turbo spin echo sequence having at least one echo train, each echo train comprising an excitation module with an excitation pulse preceding a readout module, which comprises multiple refocusing pulses and associated readout intervals, wherein the excitation pulse is at least partly implemented as a variable rate selective excitation pulse and the readout module immediately succeeds the excitation module.

All features and remarks regarding the method according to the invention may also be applied to the magnetic resonance device according to the invention and vice versa. Hence, the same advantages can be achieved.

The control device comprises at least one processor and at least one storage means. Functional units may be implemented using hardware and/or software. In addition to the acquisition unit, which may also control other acquisition processes, the control device may also comprise a reconstruction unit for reconstructing a magnetic resonance data set from acquired magnetic resonance data, in particular from magnetic resonance data acquired using the method described above.

A computer program according to the invention may be directly loaded into a storage means of a control device of a magnetic resonance device and comprises program means, such that, when the computer program is executed on the control device, the control device is caused to perform the steps of a method according to the invention. The computer program may be stored on an electronically readable storage medium according to the invention, which hence comprises control information stored thereon, which comprises at least a computer program according to the invention, such that, when the electronically readable storage medium is used in a control device of a magnetic resonance device, the control device is configured to perform a method according to the invention. The electronically readable storage medium may be a non-transient medium, for example a CD-ROM.

Other objects and features of the present invention will become apparent from the following detailed description considered in conjunction with the accompanying drawings. The drawings, however, are only principle sketches designed solely for the purpose of illustration and do not limit the invention. The drawings show:
Fig. 1 a sequence diagram for illustrating a state-of-the-art approach,
Fig. 2 a sequence diagram for illustrating a first embodiment of a method according to the invention,
Fig. 3 a sequence diagram for illustrating a second embodiment of a method according to the invention,
Fig. 4 a magnetic resonance device according to the invention, and
Fig. 5 the functional structure of a control device of the magnetic resonance device of Fig. 4.

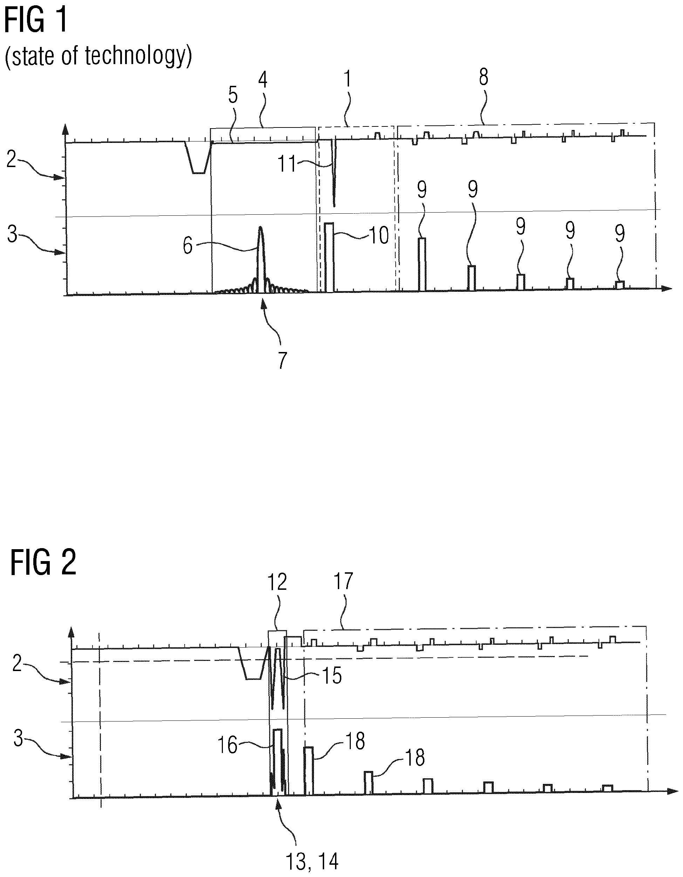

Fig. 1 illustrates a state-of-the-art approach using an additional refocusing module 1 for a slab-selective three-dimensional TSE sequence, in this case a SPACE sequence. For simplicity, in the sequence diagram, only the z gradient (upper graph 2) and the radio frequency channel (lower graph 3) are shown. The z gradient is used for slab selection.

As can be seen, the echo train illustrated in Fig. 1 comprises an excitation module 4, wherein a low-amplitude gradient pulse 5 of constant strength and a radio frequency pulse 6 are output as an excitation pulse 7. The excitation pulse 7 has a high time-bandwidth product to achieve precise slice selection. It has a long duration, which would limit the echo spacing in the refocusing train (readout module 8). In the readout module 8, refocusing pulses 9 are succeeded by respective readout intervals (not shown).

To allow shorter echo spacings and shorter TEs, the refocusing module 1 is used, which comprises an additional 180° refocusing pulse 10 and a crusher gradient pulse 11. The spin echo generated in the additional refocusing module serves as the input to the readout module 8. In this manner, echo spacings as on the non-selective case can be used. However, this solution has the disadvantages of requiring a very precise 180° refocusing pulse 10 and the crusher gradient 11 to mitigate effects of the different echo spacing of this first echo. Furthermore, when avoiding high radio frequency amplitudes to achieve the flip angle of 180°, the 180° refocusing pulse 10 has a longer duration, increasing the susceptibility for B0 inhomogeneities (imperfections). The minimum TE is increased when using the additional refocusing module 1. Finally, the long duration of the excitation pulse 7 leads to geometrical inaccuracies regarding different magnetic resonance frequencies in the slab, for example off-resonant tissues.

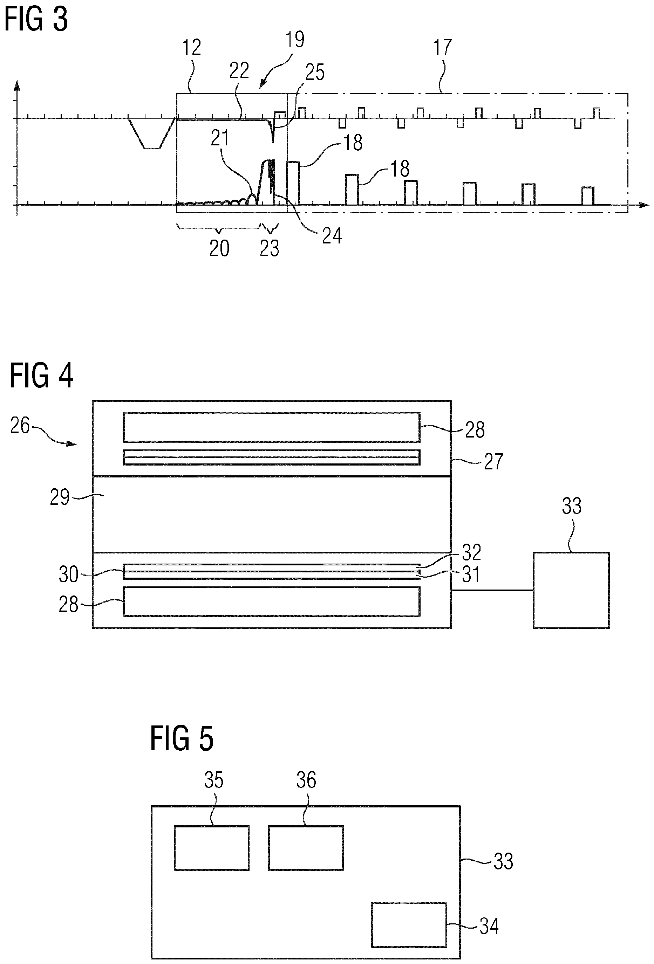

In embodiments of the current invention, it is proposed to replace the excitation pulse 7 at least partly by a VERSE pulse, shortening its duration and removing the need for the additional refocusing module 1. Concrete examples are shown in Figs. 2 and 3. Again, for simplicity, in the respective sequence diagrams only the z gradient (upper graph 2) and the radio frequency channel (lower graph 3) are shown.

Fig. 2 illustrates a first embodiment of the invention. In the excitation module 12, only a VERSE pulse 13 is used as the excitation pulse 14. The VERSE pulse 13 comprises a gradient pulse 15 having a time-varying gradient strength and radio frequency pulse 16. In this case, a minimum-time VERSE pulse 13 is used. The duration of the excitation pulse 14 is considerably shorter as the duration of the excitation pulse 7, for example reduced by a factor of nearly ten. The readout module 17 can be used immediately after the excitation module 12, since very short TEs are possible. Both embodiments shown here relate to a SPACE sequence using a CPMG train for readout, where the echo spacing of the refocusing train is twice the time between the center of the excitation pulse 14 and the center of the first refocusing pulse 18 of the refocusing module 17.

In the embodiment of Fig. 3, the fact that VERSE pulses are more prone to off-resonances caused, for example, by B0 inhomogeneities or chemical shifts is also considered. Hence, the excitation pulse 19 of the second embodiment comprises a first section 20 implemented as a first half of a slab-selective excitation pulse having radio frequency pulse 21 and a constant gradient pulse 22 and a second section 23 implemented as a VERSE pulse comprising a radio frequency pulse 24 and a gradient pulse 25 of time-varying gradient strength. The second section 23 has a shorter duration than the first section 20, since the VERSE pulse has, again, been determined as a minimum time VERSE pulse. In this manner, the use of VERSE in minimized while maximizing the relevant decrease in duration, i.e. the duration from the center of the slab-selective excitation pulse having a constant gradient pulse 22, which defines the echo spacing, on is minimized.

Fig. 4 is a schematic drawing of a magnetic resonance device 26 according to the invention. The magnetic resonance device 26 comprises a main magnet unit 27 having a superconducting main magnet 28, which defines a bore 29 into which a patient on a patient table (not shown) can be introduced for magnetic resonance imaging. Acquisition equipment 30 comprises a gradient coil assembly 31 and a radio frequency coil assembly 32, which, in this embodiment, extend cylindrically around the bore 29. The operation of the magnetic resonance device 26 is controlled by a control device 33, which is configured to perform a method according to the invention, i.e. use the sequences described with respect to Fig. 2 and/or Fig. 3 to acquire magnetic resonance data.

Fig. 5 shows the functional structure of the control device 33. The control device 33 comprises at least one processor (not shown) and a storage means 34, in which, for example, magnetic resonance data may be stored. An acquisition unit 35 controls the magnetic resonance device 26, in particular the acquisition equipment 30, to acquire magnetic resonance data, in particular according to the 3D-TSE sequences described with respect to Fig. 2 and Fig. 3. In a reconstruction unit 36, magnetic resonance image data sets may be reconstructed from the magnetic resonance data.

Although the present invention has been described in detail with reference to the preferred embodiment, the present invention is not limited by the disclosed examples from which the skilled person is able to derive other variations without departing from the scope of the invention.

Independent of the grammatical term usage, individuals with male, female or other gender identities are included within the term.

## Claims

1. Computer-implemented method for operating a magnetic resonance device (26) for acquiring magnetic resonance data, wherein an, in particular three-dimensional, slab-selective turbo spin echo sequence having at least one echo train is used, each echo train comprising an excitation module (12) with an excitation pulse (14, 19) preceding a readout module (17), which comprises multiple refocusing pulses (18) and associated readout intervals, **characterized in that** the excitation pulse (14, 19) is at least partly implemented as a variable rate selective excitation pulse (13), wherein the readout module (17) immediately succeeds the excitation module (12).

2. Method according to claim 1, **characterized in that** the variable rate selective excitation pulse (13) is determined by minimizing its duration.

3. Method according to claim 1 or 2, **characterized in that** the excitation pulse (14) is completely implemented as a variable rate selective excitation pulse (13).

4. Method according to claim 1 or 2, **characterized in that** the excitation pulse (19) comprises a first section (20) implemented as a first half of a slab-selective excitation pulse having a constant gradient pulse (22) and a second section (23) implemented as a variable rate selective excitation pulse, wherein the second section (23) has a shorter duration than the first section (20).

5. Method according to one of the preceding claims, **characterized in that** the readout module (17) comprises a CPMG readout train.

6. Magnetic resonance device (26), comprising a main magnet (28) for generating a main magnetic field, acquisition equipment (30) comprising a gradient coil assembly (31) and a radio frequency coil assembly (32) and a control device (33), wherein the control device (33) comprises an acquisition unit (35) operative to acquire magnetic resonance data using the acquisition equipment (30) and adapted to acquire magnetic resonance data using an, in particular three-dimensional, slab-selective turbo spin echo sequence having at least one echo train, each echo train comprising an excitation module (12) with an excitation pulse (14, 19) preceding a readout module (17), which comprises multiple refocusing pulses (18) and associated readout intervals, wherein the excitation pulse (14, 19) is at least partly implemented as a variable rate selective excitation pulse (13) and the readout module (17) immediately succeeds the excitation module (12).

7. Computer program comprising program means such that, when the computer program is executed on a control device (33) of a magnetic resonance device (26), the control device (33) is caused to perform a method according to any of the claims 1 to 5.

8. Electronically readable storage medium, on which a computer program according to claim 7 is stored.
